Europäisches Patentamt

European Patent Office

Office européen des brevets

(19)

(11) Veröffentlichungsnummer: **0 101 017**
**A2**

(12) **EUROPÄISCHE PATENTANMELDUNG**

(21) Anmeldenummer: **83107661.7**

(22) Anmeldetag: **03.08.83**

(51) Int. Cl.³: **H 03 K 17/292**

(30) Priorität: **17.08.82 DE 3230571**

(43) Veröffentlichungstag der Anmeldung:
**22.02.84 Patentblatt 84/8**

(84) Benannte Vertragsstaaten:
**AT BE CH DE FR GB IT LI NL SE**

(71) Anmelder: **SIEMENS AKTIENGESELLSCHAFT**
**Berlin und München Wittelsbacherplatz 2**
**D-8000 München 2(DE)**

(72) Erfinder: **Zirkl, Siegmar, Dipl.-Ing.**
**Klenze-Strasse 4**
**D-8400 Regensburg(DE)**

(54) **Elektronischer Zeitschalter.**

(57) Elektronischer Zeitschalter zum zeitlich begrenzten Einschalten von Verbrauchern, die mit Wechselspannung gespeist werden, dessen Lastteil von einem elektronischen
Steuerteil geschaltet wird und der Anschlüsse (1, 2) aufweist,
die sowohl den Lastteil als auch den Steuerteil speisen,
indem im Ruhezustand über einen Gleichrichter (7) ein erster
Speicher (9) aufgeladen wird, der beim Einleiten des Lastbetriebs mittels Taster (10) mit Umschaltfunktion einen zweiten
Speicher (11) über einen Umladezweig mit Strombegrenzungswiderstand (33) auflädt. Nach der Erfindung ist vorgesehen, daß der Umladezweig eine Parallelschaltung aus
ohmschem Widerstand (43) und Schwellwertventil (44) aufweist.

FIG 1

EP 0 101 017 A2

SIEMENS AKTIENGESELLSCHAFT          Unser Zeichen
Berlin und München                  VPA 82 P 3 2 5 2 E

Elektronischer Zeitschalter

Die Erfindung bezieht sich auf einen elektronischen Zeitschalter nach Oberbegriff des Patentanspruches 1. Ein solcher Zeitschalter weist zum zeitlich begrenzten Einschalten von Verbrauchern, beispielsweise von Lampen, die mit
Wechselspannung gespeist werden, einen Lastteil auf, der
von einem elektronischen Steuerteil geschaltet wird. Seine
zwei Anschlüsse speisen sowohl den Lastteil als auch den
Steuerteil, indem im Ruhezustand über einen Gleichrichter
ein erster Speicher aufgeladen wird, der beim Einleiten
des Lastbetriebs mittels Taster und Umschaltfunktion einen
zweiten Speicher über einen Umladezweig mit Strombegrenzungswiderstand auflädt. Ein solcher Zeitschalter ist bereits vorgeschlagen worden (P 31 11 753.8).

Beim eingangs geschilderten Zeitschalter kommt man mit
zwei Anschlußleitungen aus, im Gegensatz zu sonst üblichen elektronischen Zeitschaltern, die sowohl zum Einschalten der Last als auch für den elektronischen Steuerteil eigene Stromversorgungsleitungen, also insgesamt mehr
als zwei - häufig vier Leitungen - benötigen. Ein solcher
Zeitschalter läßt sich daher leicht in vorhandene Installationsdosen im Austausch gegen einen Installationsschalter einsetzen. Die Betriebsdauer für eine einzuschaltende
Last läßt sich beim geschilderten Zeitschalter an einem
Zeitglied einstellen, das zum zweiten Speicher parallelgeschaltet ist und aus einem festen ohmschen Widerstand und
aus einem einstellbaren Widerstand, beide in Reihe, besteht. Schaltet man einen solchen Zeitschalter von Hand ein, so wird ein Verbraucher im Lastteil während einer zuvor fest eingestellten Zeit in Betrieb gesetzt.

Der Erfindung liegt die Aufgabe zugrunde, den eingangs geschilderten Zeitschalter so weiterzubilden, daß die Einschaltdauer einer Last im Einzelfall durch unterschiedlich langes Betätigen eines Bedienungsknopfes individuell eingestellt werden kann.

Die Lösung der geschilderten Aufgabe besteht darin, daß der Umladezweig eine Parallelschaltung aus ohmschem Widerstand und Schwellwertwiderstand aufweist. Hinsichtlich des zuvor geschilderten Zeitschalters entfällt also das Einstellpotentiometer aus festem Widerstand und einstellbarem Widerstand, und im Umladezweig ist die Parallelschaltung aus ohmschem Widerstand und Schwellwertwiderstand angeordnet. Im ausgeschalteten Zustand wird der erste Speicher aufgeladen. Wird der Taster betätigt, so wird der zweite Speicher über den Stromnegrenzungswiderstand und das Schwellwertventil, beispielsweise eine Zenerdiode, aufgeladen. Wenn die Potentialdifferenz zwischen dem ersten und dem zweiten Speicher unter den Schwellwert, bei einem Schwellwertventil in Durchlaßrichtung, abfällt, und der Taster weiterhin gedrückt wird, so findet eine weitere Umladung zwischen dem ersten Speicher auf den zweiten Speicher über den Widerstand aus Strombegrenzungswiderstand und dem ohmschen Widerstand der Parallelschaltung statt. Entsprechend der unterschiedlichen Aufladung des zweiten Speichers bleibt der Zeitschalter entsprechend lange eingeschaltet. Andererseits ist bei einem solchen Zeitschalter auch ein Nachschalten während des Betriebs möglich.

Wenn die Kapazität des ersten Speichers zur Kapazität des zweiten Speichers im Verhältnis von zwei bis sechs steht, ergeben sich in der Praxis günstige Einschaltverhältnisse. Insbesondere ist vorteilhaft, die Speicherkapazitäten so zu wählen, daß die Kapazität des ersten Speichers zu der des zweiten Speichers im Verhältnis von drei bis fünf steht. Bei einem in der Praxis zweckmäßig bemessenen Strombegrenzungswiderstand, um die Kontakte des Tasters zu schonen, ergeben sich dann minimale Einschaltzeiten zwischen etwa dreiviertel Minute und anderthalb Minuten, je nachdem, wie lange der Taster betätigt wird. Eine größere Zeitkonstante, bedingt durch den zweiten Speicherkondensator und den Widerstand der Parallelschaltung würde die Minimalzeit verlängern.

Die Erfindung soll anhand eines in der Zeichnung grob schematisch wiedergegebenen Ausführungsbeispiels näher erläutert werden:

In Fig. 1 ist der schaltungsmäßige Aufbau des Zeitschalters wiedergegeben.
In Fig. 2 ist ein Installationsschalter in Seitenansicht veranschaulicht, der im wesentlichen dadurch als Zeitschalter ausgebildet ist, daß er eine Platine mit einer Schaltung nach Fig. 1 aufnimmt.

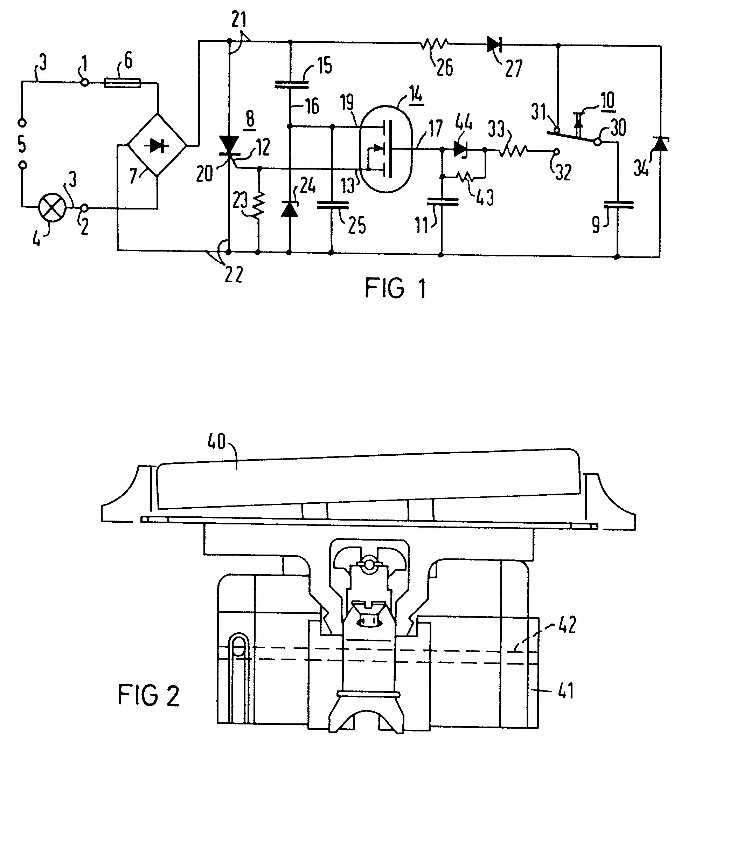

Die elektrischen Bauteile des Zeitschalters sind in Fig. 1 dargestellt. An den Anschlußklemmen 1 und 2 sind die beiden Schaltleitungen 3 zu einem Verbraucher 4 angeschlossen, der von einem Netz 5 versorgt wird. Im Ausführungsbeispiel gelangt man vom Anschluß 1 über eine Sicherung 6 zu einem Gleichrichter 7, im Ausführungsbeispiel als Doppelweggleichrichter ausgebildet. Die Anschlüsse 1 und 2 des Lastteils mit einem Lastventil 8 speisen zugleich das Steuerteil. Hierzu wird im Ruhezustand über den Gleichrichter 7 ein erster Speicher 9 aufgeladen, der beim Einleiten des Lastbetriebs mittels eines Tasters 10 mit Umschaltfunktion einen zweiten Speicher 11 auflädt. Dieser speist dann das Steuerteil.

Die Anschlüsse 1 und 2 sind im Ausführungsbeispiel nach Fig. 1 mit einem Gleichrichter verbunden. Der Gleichrichter 7 ist im Ausführungsbeispiel durch einen Doppelweggleichrichter ohne Glättung verwirklicht. In seinem gleichgerichteten Kreis ist ein elektronisches Lastventil 8 angeordnet, dessen Steuereingang 12 mit einem Ausgang 13 eines elektronischen Steuerventils 14 verbunden ist. Das Lastventil 8 kann insbesondere ein Thyristor sein. Der andere Ausgang des Steuerventils 14, also der Ausgang, der nicht mit dem Steuereingang 12 des Lastventils 8 verbunden ist, ist über eine mit Kapazität 15 versehene Leitung 16 mit dem ersten Zweig im gleichgerichteten Kreis verbunden. Das Steuerventil 14 ist mit seinem Steuereingang 17 mit dem zweiten Speicher 11 verbunden.

Der zweite Zweig 22 im gleichgerichteten Kreis ist außer mit einem Ausgang 20 des Lastventils über einen Widerstand 23 mit dessen Steuereingang 12 verbunden. An diesem zweiten Zweig 22 ist weiter das Steuerventil 14 an seinem Ausgang 19 und weiter der zweite Speicher 11 sowie der erste Speicher 9 angeschlossen. Die Speicher 9 und 11 sind im Ausführungsbeispiel als Kondensatoren ausgebildet.

Im Ausführungsbeispiel nach Fig. 1 ist das Steuerventil 14 als ein MOS-Feldeffekttransistor, MOS-FET, ausgebildet.

Zwischen dem zweiten Zweig 22 und dem Ausgang 19 des Steuerventils 14, an dem der Steuereingang 12 des Lastventils 8 nicht liegt, ist eine Zenerdiode 24 und ein parallel liegender Kondensator 25 angeordnet. Diese sind darauf abgestimmt, den MOS-FET gegen zu hohe Spannungen zu schützen und sein Abschaltverhalten zu unterstützen.

Der erste Zweig 21 des gleichgerichteten Kreises ist im Ausführungsbeispiel über einen Widerstand 26 und über eine Diode 27 in Durchlaßrichtung mit dem Taster 10 verbunden. Der Widerstand 26 trennt dabei den Lastteil vom Steuerteil und die Diode 27 sperrt die Entladung des ersten Speichers 9 im eingeschalteten Zustand des Zeitschalters.

Der Taster 10 bildet im Ruhestand einen leitenden Durchgang von der Diode 27 zum ersten Speicher 9, wobei dieser am Dauerkontakt 30 angeschlossen ist. Der Kontakt 32, zu dem im eingeschalteten Zustand vom Kontakt 31 umgeschaltet und ein leitender Durchgang hergestellt wird, ist mit dem zweiten Speicher 11 über einen Widerstand 33 auf der Seite zum Steuereingang 17 des Steuerventils 14 verbunden.

Zwischen dem ersten Zweig 21 und dem zweiten Zweig 22 ist parallel zur Reihe aus Taster 10 und dem ersten Speicher 9 ein Schwellwertschalter, im Ausführungsbeispiel eine Zenerdiode 34, angeschlossen. Diese sorgt dafür, daß der erste Speicher 9 bis zu einem definierten Spannungswert aufgeladen wird und im Ladezustand gehalten wird, solange die Taste 10 gedrückt bleibt.

In einem handelsüblichen Installationsschalter nach Fig. 2, dessen Handbetätigungsorgan 40 als Taster ausgebildet ist, kann in seinem Sockel 41 eine Platine 42 angeordnet sein, die die Bauteile und Leitungsverbindungen nach Fig. 1 aufnimmt.

Der Zeitschalter funktioniert wie folgt:

Im ausgeschalteten Zustand richtet der Gleichrichter 7 die anstehende Spannung gleich. Über den Widerstand 26 und die Diode 27 wird der erste Speicher 9 bis auf einen Spannungswert aufgeladen, der der Zenerspannung der Zenerdiode 34 entspricht.

Das Steuerventil 14, der MOS-FET, ist dann gesperrt. Über den Widerstand 23 liegt der Steuereingang 12 des Lastventils 14, im Ausführungsbeispiel ein Thyristor, auf dem Bezugspotential O. Das Lastventil 12 ist dabei nichtleitend. Wird die Taste 10 betätigt, fließt ein Teil der Ladung des Speichers 9 über den Strombegrenzungswiderstand 33, der einen Kontaktschutz darstellt, und über das Schwellwertventil 44, beispielsweise eine Zenerdiode, in den Speicher 11. Das Steuerventil 14 wird durch die positive Spannung am Steuereingang geöffnet. Wegen der Welligkeit der im Gleichrichter 7 gleichgerichteten Spannung fließt ein Strom über den Kondensator 15 durch das Steuerventil 14 und den Widerstand 23. Am Widerstand 23 entsteht dabei ein Spannungsabfall, der das Lastventil 8 leitend steuert. Der Zeitschalter ist jetzt eingeschaltet und eine Last, beispielsweise eine Lampe 4, wird mit Spannung versorgt. Sinkt der Potentialunterschied zwischen dem ersten Speicher und dem zweiten Speicher unter die Schwelle, bei der das Schwellwertventil 44 noch leitend ist, so kann bei längerer Betätigung des Tasters 10 der zweite Speicher 11 über den Parallelwiderstand 43 weiter aufgeladen werden. Man erzielt dadurch entsprechend längere Einschaltzeiten des Zeitschalters.

Unterschreitet die Spannung am Steuereingang 17 des
Steuerventils 14 einen bestimmten Wert, wird das Steuerventil 14 gesperrt und der Steuereingang 12 des Lastventils 8 wird auf Bezugspotential 0 gelegt. Das Lastventil
12 wird nichtleitend und der Zeitschalter ist wieder in
seine Ruhestellung zurückgegangen. Eine Last, beispielsweise eine Lampe 4, wird nicht mehr versorgt, da der
Stromkreis unterbrochen ist.

Es ist möglich, den eingeschalteten Zeitschalter nachzuschalten und dadurch die Betriebsdauer zu verlängern.
Das ist so lange möglich, bis vom ersten Speicher 9 auf
den zweiten Speicher 11 keine ausreichende Ladung mehr
umgeladen werden kann. Der Zeitschalter schaltet also
sicher ab. Im eingeschalteten Zustand sorgt die Diode 27
dafür, daß sich der erste Speicher 9 nicht über das Lastventil 8 entladen kann.

Wenn die Kapazität des ersten Speichers zur Kapazität
des zweiten Speichers im Verhältnis von drei bis fünf
steht, kann man bei einer Betätigungsdauer des Tasters
10 von zwei Sekunden etwa eine Einschaltdauer zwischen
vier und fünf Minuten erzielen und bei einer Betätigung
von sechs Sekunden eine Einschaltdauer zwischen fünf und
sechs Minuten.

Die Sicherung 6 schützt den Gleichrichter 7 und das Lastventil 8 vor Überlast und vor Kurzschluß.

3 Patentansprüche
2 Figuren

Patentansprüche

1. Elektronischer Zeitschalter zum zeitlich begrenzten Einschalten von Verbrauchern, die mit Wechselspannung gespeist werden, dessen Lastteil von einem elektronischen Steuerteil geschaltet wird und der Anschlüsse (1, 2) aufweist, die sowohl den Lastteil als auch den Steuerteil speisen, indem im Ruhezustand über einen Gleichrichter (7) ein erster Speicher (9) aufgeladen wird, der beim Einleiten des Lastbetriebs mittels Taster (10) mit Umschaltfunktion einen zweiten Speicher (11) über einen Umladezweig mit Strombegrenzungswiderstand (33) auflädt, d a d u r c h   g e k e n n z e i c h - n e t, daß der Umladezweig eine Parallelschaltung aus ohmschem Widerstand (43) und Schwellwertventil (44) aufweist.

2. Elektronischer Zeitschalter nach Anspruch 1, d a - d u r c h   g e k e n n z e i c h n e t, daß die Kapazität des ersten Speichers (9) zur Kapazität des zweiten Speichers (11) im Verhältnis von zwei bis sechs steht.

3. Elektronischer Zeitschalter nach Anspruch 1, d a - d u r c h   g e k e n n z e i c h n e t, daß die Kapazität des ersten Speichers (9) zur Kapazität des zweiten Speichers (11) im Verhältnis von drei bis fünf steht.

FIG 1

FIG 2